Europäisches Patentamt

European Patent Office

Office européen des brevets

(19)

(11) Publication number: 0 203 635

A1

# (12) EUROPEAN PATENT APPLICATION

(21) Application number: 86200702.8

(51) Int. Cl.⁴: **B44C 1/14** , H05K 3/02

(22) Date of filing: 24.04.86

(30) Priority: 10.05.85 GB 8511905
03.07.85 NL 8501903

(43) Date of publication of application:
03.12.86 Bulletin 86/49

(84) Designated Contracting States:
AT BE CH DE FR GB IT LI LU NL SE

(71) Applicant: **AKZO N.V.**
**Velperweg 76**
**NL-6824 BM Arnhem(NL)**

(72) Inventor: **Cooray, Bulathsinhalage Boyd**
**11, Broadoak Road Bamford**
**Rochdale Manchester(GB)**
Inventor: **Hope, Peter**
**Rijksstraatweg 139**
**NL-7391 MK Twello(NL)**
Inventor: **Vleggaar, Jan**
**Lorentzlaan 36**
**NL-7002 HB Doetinchem(NL)**
Inventor: **Helle, Kees**
**Edeseweg 105**
**NL-6721 JS Bennekom(NL)**
Inventor: **Roos, Arie**
**Wulpenstraat 4**
**NL-6883 ET Velp (Gld.)(NL)**

(74) Representative: **Sieders, René et al**
**P.O. Box 314**
**NL-6800 AH Arnhem(NL)**

(54) Metallized polymer compositions, processes for their preparation and their uses.

(57) Metallized polymer compositions are disclosed, the surface of which comprises a combination of a metal element A (Sn, As, Sb or Bi) and a metal element B (Fe, Co, Ni, Cu, Zn, Ga, Ru, Rh, Pd, Ag, Cd or In), preferably an intermetallic compound of antimony and a metal element B. Processes for producing such metallized polymer compositions involve either the reduction of a metal element A compound in the presence of metallic metal element B and the polymer or the compression of a laminate of antimony and metal element B layers onto the polymer. The metallized polymers are useful in the production of printing circuit board, electromagnetic interference shielding devices, membrane switches, capacitors, conductive fibers, magnetic tapes and discs, anti-static mats, barrier polymers or optical storage devices.

## Metallized polymer compositions, processes for their preparation and their uses

The present invention relates to polymer compositions which are metallized, in particular with intermetallic compounds. The invention also relates to convenient processes for preparing such metallized polymer compositions. Furthermore, the invention relates to a process for producing electrically conductive films. Finally, the invention envisages advantageous uses of the processes.

In the development of currently available commercial processes of producing satisfactory metal-to-plastic bonding the plating of polymeric materials has met increasing interest and found widening application. The replacement for metal articles by plastic items obviously offers the advantages of lower cost, higher production speed, wider design latitude, weight savings and fewer corrosion problems in view of the applicable extrusion and injection moulding techniques, and the inherent properties of the polymeric materials. For many application purposes, however, a metallic coating on the polymeric article is desirable, since in that way the hardness, wear resistance, shiny appearance and metallic feel characteristic of metals is imparted to the polymeric substitutes. Further more, mention should be made of printed circuit boards which comprise dielectric substrates carrying metal electrical circuits. Finally the plating of plastic articles has found application in shielding electromagnetic interference (EMI) from electronic equipment. This EMI causes problems to advanced electronic devices of great sensitivity. Regulations concerning this new electronic pollution are or will be effective in USA and Europe. Since most plastic surfaces are not electrically conductive, the traditional electroplating methods are not quite suitable for providing a metallic coating.

Currently electroless plating is one feasible method for the plating of polymeric materials. Though the development of chemical etchants resulting in a controlled microporous surface of the polymeric material and greatly improved electroless plating baths has led to metal depositions which adhere well to the polymeric surface and may serve as a conductive preplating for subsequent electroplating, all electroless plating processes are labour intensive, complicated and hence expensive. For, a typical electroless plating procedure involves the steps of etching with strongly oxidizing solutions of chromic acid in order to physically roughen the polymeric surface and chemically modifying it to give it a hydrophilic nature, neutralizing with usually a mildly acidic or basic reducing agent for removing the detrimental hexavalent chromium, sensitizing with stannous chloride and palladium chloride for nucleation of palladium, accelerating with acidic of basic solutions for removing excess tin and exposing palladium nuclei and electroless depositing metals such as nickel and copper from a plating bath.

Other current techniques, such as vacuum metallizing and cathode sputtering, are available - (Modern Plastics Encyclopedia 1982-1983, p. 405-423), but are not always useful.

In view of the increasing need for plated polymeric articles it will be clear that there is still a great demand for such a simple method providing an adhering interface between a polymeric material and a metallic or pseudo-metallic layer, as will be less cumbersome and complicated than the prior art method discussed above.

It should be noted that a method for highspeed production of metal-clad articles is disclosed in the International Patent Application WO 83/02784, which method comprises electroplating the injection moulding die surface prior to each moulding operation of a plastic article and the transfer of the electrodeposit to the plastic surface as a result of the higher adhesion of the electrodeposit to the plastic article formed than to the surface of the mould member. This method, however, comprises the preliminary formation of the metallic layer and subsequent bonding to the polymeric article during formation of the latter.

Further, it is known from the GB Patent 1 309 320 that flammable plastics can be compounded with combinations of halogen containing low molecular weight compounds and antimony trioxide. It is stated therein that certain additives tend to effloresce through lack of compatibility with the plastics material, which over a period of time, can result in thick coatings being formed on the surfaces of moulding or machine parts. The nature of such coatings, however, is not defined, and no use is mentioned.

From EP Patent Application 125 617 it is known to metallize polymer compositions by heat treatment of a composition of a polymer and an organic complex of a transition metal element. A metallized surface film was obtained when the heat treatment was conducted with the polymer composition being in intimate contact with a metallizing board, which must be made of a material having adequate heat resistance and being readily releasable from the metallized film. The metal layers obtained do not contain a main group element.

In US Patent No. 3 620 834 a method is disclosed for metal plating plastic materials, wherein a substrate is successively pretreated with a main group V element trichloride and a source of sulfide prior to electrodeposition of Ni or Cu by conventional techniques.

From German Patent Application No. 2 022 109 it is known to treat in the presence of a solvent the surface of an plastics article with a dissolved metal salt complex, such as $SnCl_2 \bullet DMSO$, which diffuses into the plastics material during treatment and is anchored therein. The surface treated may be sensitized with a different metal salt, such as $AgNO_3$, under reducing conditions, so that a metallic layer of the latter metal is deposited.

US Patent Application No. 420 054, filed 20 September 1982 and published 2 March 1984, Chem. Abstr., Vol. 100, 211213t (1984) discloses a process for plating a main group metal on aromatic polymers by the use of a non-aqueous solution of a salt of an alkali metal in a positive valency state and a main group metal in a negative valency state, for example $K_4Sn_9$. Metal plating is accomplished by immersion of the polymer into the solution followed by washing with toluene. However, the present process is not a wet process.

An article in The Journal of Vacuum Science and Technology, Vol. 9, No. 1, pp. 354-6 describes the preparation of intermetallic compounds, specificly of niobium and tin, $Nb_3Sn$, by coevaporation of two metals onto a rotating surface. A plurality of successive thin layers each of the thickness of approximately one lattice constant should be deposited for properly producing the intermetallic compound, which finally is collected from the carrying surface.

The present invention has for its object to provide new metallized polymer compositions which can be readily produced.

Accordingly, the present invention provides a metallized polymer composition of which the surface is at least partially metallized with a surface layer containing a metal element A selected from the group consisting of tin, arsenic, antimony and bismuth and a metal element B selected from the group consisting of iron, cobalt, nickel, copper, zinc, gallium, ruthenium, rhodium, palladium, silver, cadmium and indium. Preferably, the metal element A is antimony.

The metallic surface layer of the present metallized polymer compositions contains in admixture at least two metal elements selected from each of the groups A and B defined above. Usually the combinations of metal elements constitute distinct intermetallic compounds, such as $Cu_2Sb$, $FeSb_2$, $NiSb$, $NiSb_2$, $SbZn$, $Sb_3Zn_4$ and $InSb$. Such inter-

metallic surface layers appear to adhere well to the various polymer compositions. They are electrically conductive to an extent which depends upon the nature of the intermetallic compound and the thickness of the layer. For many of the applications mentioned earlier the electric conductively is sufficiently high and the present metallized polymer materials are useful as such. If desired, the intermetallic surface layers may be plated with any further metal or metal combination, which is effected most conveniently by electrodeposition in that the surface has become electrically conductive.

The present metallized polymer compositions can be readily produced by techniques which are basically either of a chemical or of a physical nature. In the preferred process embodiments of the present invention such chemical or physical processes are effected when at elevated temperature and at elevated pressure the metallic precursors are in contact with the surface of the (pre)-polymer composition to be metallized, so that the latter is in the thermoplastic state or is subject to a thermosetting reaction. It is believed that the excellent adhesion is at least partially due to such a contact during the formation of the intermetallic compound. So, for example, it has been observed that when subjecting a laminate of a copper foil, an intermediate relatively thin layer of antimony and a plastics sheet, such as an ABS-sheet, to heat and pressure the antimony diffuses into the copper surface layer with formation of the $Cu_2Sb$ intermetallic compound. After cooling the bond between the ABS-sheet and the intermediate $Cu_2Sb$ layer appears to be stronger than the bond between $Cu_2Sb$ layer and the remainder of the copper foil. When the ABS-sheet is separated from the copper foil, the laminate is split at the interface $Cu/Cu_2Sb$ and effectively the surface layer of the starting copper foil, together with the antimony diffused therein is transferred to the ABS-sheet in the form of a well-adhering intermetallic compound coating.

For producing the metallized polymer composition the invention provides a first process which is basically of a chemical nature, in which process a compound or mixture of compounds containing a positively valent metal element A selected from the group consisting of tin, arsenic, antimony and bismuth is brought into reaction with a metallic source of a metal element B selected from the group consisting of iron, cobalt, nickel, copper, zinc, gallium, ruthenium, rhodium, palladium, silver, cadmium and indium at the surface of the polymer composition to be metallized under conditions such that said metal element is deposited to form a surface layer of the polymer composition containing both the metal element A and the metal element B.

According to a first embodiment of the chemical process of the invention the compound or mixture of compounds containing the metal element A and the source of a metal element B are simply brought together on the surface of the polymer composition to be metallized. If necessary, reaction may subsequently be initiated by elevating temperature and/or pressure.

According to a second embodiment of the chemical process of the invention a support surface is provided, on to which the polymer composition carrying the combination of metal element A compound and metal element B source is pressed. Alternatively, the reactive combination may be applied to the support surface. The support surface will determine the shape of the metallized surface of the polymeric endproduct.

According to a third embodiment of the chemical process of the invention a metallic surface is used, which functions both as a source of a metal element B and as a support surface. The polymer composition is pressed on to this metallic surface in the presence of the metal element A compound, which may previously have been applied to either surface or to both surfaces of the polymeric and metallic materials by common procedures such as spraying, dusting or brushing.

According to a fourth embodiment of the chemical process of the invention said compound or mixture of compounds is incorporated into the polymer composition before the latter is pressed onto a metallic surface containing the metal element B. This embodiment may be preferred, if the contact face is of irregular shape and the contacting is to be combined with a moulding operation of the polymer composition. Under suitable process conditions said compound or mixture of compounds, or further products formed thereof will prove to be sufficiently mobile in the polymeric mass to reach the surface of the polymer mass within the applied time parameter, so that a thick surface layer relative to be concentration in the bulk of the polymer composition can be formed.

Effective compositions may further contain suitable inert excipients.

Of course, the basis features of the above embodiments may be combined within the scope of the invention. For example a metallic surface containing a metal element B may be used, and further metallic particles containing a metal element B may be provided between the metallic surface and the polymer composition together with the metal element A compound. In that case the metallic surface and the metallic particles may contain different metal elements B.

The essential reactions of the compound or mixture of compounds containing the metal element A may take place at the surface of metal element B metallic particles surrounded by the polymer composition. In that case the metallic particle will remain enveloped within a layer containing the deposited combination of the metal elements A and B which is formed in the process of the invention. Since this layer appears to be in electrically conductive contact with the metallic particle contained therein, its formation according to the invention may be used in the production of electrically conductive films.

The invention provides a further embodiment a process for producing electrically conductive films which process comprises the steps of incorporating a compound or mixture of compounds containing a metal element A and metallic particles containing a metal element B into a thermosetting polymer composition to obtain a paste, spreading said paste to form a film, subjecting said film to heating in such a manner that the thermosetting material is cured and the metal element A is brought into reaction with the metallic particles with formation of a continuous network of interconnected envelopes of individual metallic particles contained in a polymer matrix, said interconnected envelopes containing the metal element A and the metal element B.

The interconnected envelopes of metallic particles obtained in this further embodiment of the invention are in contact with internal surfaces of the polymer composition and may be considered to be internal surface layers of the polymer composition.

The expression "metal element", as used in the present specification and claims, is meant to encompass both metal elements and semi-metal elements, since no sharp division between them can be made. "Polymer composition" is any composition containing a polymer or copolymer as main constituent together with any additives being inert in the present process. The (co)polymers may be thermoplastic or thermosetting.

In the chemical process according to the invention use in made of a compound or mixture of compounds containing a metal element A which will be in a formally positive valency state. Of course, in the surface layer forming stage of the process at least one reactive compound must be present, but such a reactive compound may very well be formed in situ, in which case a mixture of compounds is used comprising precursors for the reactive compounds. Such precursors will in general comprise an inactive or less reactive source of the metal element A as first constituent and an activating compound as second constituent. The use of precursors may be preferred in view of availability of starting materials and most of all when an induction time, induction temperature or induction pressure is desirable, for initiating the surface layer forming reaction.

As result of the reaction of a metal element A compound with a metallic metal element B source some reaction products containing said metal element A are deposited together with the metal element B to form a surface layer of the polymer composition. Herein the combination of metal element A and metal element B is neutral, and can be an alloy or an intermetallic compound of the metal elements.

In its broadest scope the invention comprises the formation of surface layers containing a metal element A selected from the group tin, arsenic, antimony and bismuth.

In order to obtain mixed surface layers it is of course within the scope of the invention to use reactive compositions containing more than one of the metal elements A indicated.

Reactive compounds of the metal element A comprise, for example, hydrides, halides, phosphides, sulfides, nitrates, carboxylates and tartrates and mixed compounds of the metal elements mentioned above. Examples are halides, such as stannous chloride, antimony trichloride, bismuth trichloride, bismuth pentabromide, antimony chloro dibromide, bismuth difluoro chloride, phosphides such as tin phosphides, sulfides such as arsenic sulfide, antimony sulfide, hydrides, and mixed compounds such as antimony iodo sulfide, and bismuth oxyfluoride.

Other sources of the metal element A usable in the process of the invention, which may be less reactive or inactive and which preferably are used as precursor in combination with an activating compound, include oxides, some sulfides, nitrides, salts of mineral acids, amphoteric oxides and salts of amphoteric elements, carbonates of the metal elements mentioned before. Also included are complexes or chelates of these metals and organo metal derivatives. Specific examples are arsenic oxide, bismuth oxide, tin oxides, etc.

Examples for a preferred metal element A, such as antimony, include antimony oxides, nitrates, oxyhalides, stearates and mercaptoacetates, organo-antimony compounds, and organic chelats of antimony.

When used as a precursor, a second constituent is required, which will provide the halogen, sulfur, phosphorus, hydrogen, nitrate, carboxylate or tartrate group for formation of the reactive compounds. As the halides of antimony, bismuth and tin are the preferred compounds for use in the process of the invention, the second constituent of the precursors preferably comprises a halogen source, which may contain the halogen both as radical and as ion. The halogen source may comprise organic chloro, bromo, fluoro and iodo compounds as well as inorganic chloro, bromo, fluoro and iodo compounds, including organo metallic halides. The halogen source may be a halogen containing polymeric component of the polymer composition.

For producing the metallized polymer composition the invention provides a second process, which is basically of a physical nature, in which process at least one layer of zero-valent antimony together with at least one layer of a metal element B selected from the group consisting of iron, cobalt, nickel, copper, zinc, gallium, ruthenium, rhodium, palladium, silver, cadmium and indium are brought into contact with a polymer or prepolymer composition under conditions such that a polymer composition is formed having a surface layer comprising an intermetallic compound of antimony and the metal element B.

In the physical process of the invention both the antimony, as preferred metal element A, and the metal element B are provided as zero-valent starting materials in separate layers.

The layers are provided on top of each other and then together they are pressed onto the polymer composition, preferably at elevated temperature. The polymer composition may be in direct contact with either an antimony or a metal element B layer.

Conveniently, a layer of antimony is deposited upon a metal element B layer, which in itself may be a layer deposited on an inert release substrate, in which case the total matter of the two deposited layers in the form of a single intermetallic compound layer is transferred from the release substrate to the polymer composition surface. Alternatively, the metal element B layer is constituted by the surface layer of a bulk body consisting essentially of the metal element B, in which case a thin surface layer thereof is combined with the antimony to form the intermetallic compound and transferred to the polymer composition surface.

According to a first embodiment of the physical process of the invention a layer of antimony is deposited, for example electrodeposited, onto a foil of the metal element B, where upon the coated foil is pressed onto a polymer composition and the assembly is kept at an elevated temperature for a sufficiently long time to complete formation of the intermetallic compound. After cooling the polymer composition carrying at its contact surface a layer of the intermetallic compound is separated from the foil, which after cleaning, if desired, may be used in a next cycle. Since in each cycle some of the metal element B is removed from the foil, it can only be used in a limited number of cycles. An advantage of this embodiment, however, is the fact that the thicknesses of the starting layers are not critical, since the formation of the intermetallic compound will just consume the stoechiometrically required amount relative to the amount of antimony deposited.

According to a second embodiment of the physical process of the invention an inert release substrate, for example an endless belt, is provided, on which subsequently a layer of antimony and a layer of the metal element B are deposited, for example by electrodeposition, in either sequence. Any desired number of layers may be deposited in a sandwich-like arrangement.

Thereupon, the inert substrate carrying the combined depositions is pressed onto a polymer composition, which for example is in the form of an endless foil, at elevated temperature. The deposited layers of antimony and the metal element B may be preheated for a certain time in order to avoid too long residence times of the polymer composition in the heated contact step. Finally, the polymer composition coated with the intermetallic compound may be separated from the inert release substrate. This second embodiment may advantageously be carried out in a continuous mode.

In both embodiments also the combined layers of antimony and the metal element B may be brought into contact with a prepolymer composition comprising precursors for the final polymer. For example, such precursors may be charged upon an endless belt previously coated with antimony and metal element B layers, whereupon the assembly is heated and pressurized, inducing both the intermetallic compound formation and the polymerization.

Although electrodeposition is preferred, any other known method for depositing a metal layer upon a substrate, such as electroless deposition, vacuum metallizing, and cathode sputtering may be used to prepare the assembly of layers of antimony and the metal element B respectively.

The process conditions of both the chemical and the physical process of the invention may in principle be widely varied. The process temperature will be limited by the degree of heat resistance of the polymeric material used.

Low temperature should be avoided if they lead to lengthy reaction times. Preferably the processes of the invention are carried out at a temperature in the range of from 70°C to 600°C, whereas a range of from 100°C to 350°C is particularly preferred, and a range of from 200°C to 250° is most preferred.

In principle any pressure may be used in the processes of the invention. In many cases, however, better contacting will be achieved at elevated pressures. Preferably the pressure ranges from 100 kPa to 100 MPa abs.

Optimum temperature and pressures can easily be determined empirically for any given case.

In the chemical process of the invention the compound or mixture of compounds containing the metal element A is reacted with a source of the metal element B. The source may be of a pure metal element B, but may also be of an alloy thereof. But the metal element B will be contained in its zero valency state. The source may be the metallic surface of a bulk body of homogeneous composition, but may also be a metallic coating on a body of any other composition. When the process is carried out at elevated pressure, for example a standard mould may be used, on the surface of which a metallic sheet of the metal element B is placed.

Preferably the metal element B is chosen from the group consisting of nickel, copper, zinc and indium.

Within this group copper is especially preferred. When copper is selected as the metal element B, such a surface layer will be obtained as has been proved to be an excellent base for further electrodeposition.

The polymer composition used in the process of the invention comprise polymers such as thermoplastics, thermosets, thermoplastic rubbers, elastomers and their blends. Examples of suitable polymers are polyolefins, polystyrenes, polyvinyl halides, polycarbonates, polyesters, polyamides, polyimides, polyetherimides, polysulfones, polyethersulfones, polyetheretherketones, polyacrylonitrile, polychoroprene, polyphenylene oxide, fluoropolymers, silicones, cellulosics, chlorosulphonated polyethylene, nitrilebutadiene rubbers, polyurethanes, phenolformaldehyde resins, melamine formaldehyde resins and urea formaldehyde resins and copolymers thereof. Of special advantage is the use of copolymers of acrylonitrile, butadiene and styrene.

Further examples of suitable (co)polymers include polypropylene oxide, polypropylene sulfide, polyacrylates, polyalkylacrylates, polysulfide polymers, polythiazoles, polyethers, polythioethers, polyureas, polyvinyl acetates, polyvinyl alcohol, polyvinyl butyral, polyvinyl carbazole, polyvinyl fluoride, poly(p-phenylene), polyacetates, polyacrolein, polyacrylic acid, phenolics, epoxy resins, and ethoxylated bisphenol-A-dimethacrylates.

The polymer compositions used may comprise above polymers in combination with common fillers, diluents, reinforcing agents, extenders and similar additives, such as stabilisers, antioxidants, pigments, etc. The additives may include quaternary ammonium salts for increasing the polarity of the polymer composition, which may in some case improve the adhesion to the polymer surface and/or the mobility of the reactive compounds containing the metal element A in the plastic polymeric mass during contacting.

In the processes according to the invention the metallization is effected at temperatures and pressures as indicated above during periods of time ranging from a few seconds to a number of minutes or several hours, depending on the thickness of the surface layer desired and the process parameters. The polymer composition may be premoulded and simply be placed in contact with a metallic surface of similar shape. Optionally the polymer composition is pressed against the metallic surface. Preheating to the desired process temperature may be effected prior to contacting, but alternatively the assembly of metallic surface and polymeric material may pressed together first and subsequently be heated.

If partial coating of the polymeric moulding is aimed at, the polymeric moulding may be contacted with a partially embossed surface or the composition containing the metal element A may be present in pre-determined contact face areas.

According to the invention contacting also may be effected during the moulding of a polymeric article. In that case a metallic mould or a mould lined with a metallic sheet will provide the metallic surface which will both be determinative of the shape of the moulded polymeric article and lead to the formation of the surface layer desired. The use of a metallic lining will lead to avoiding any loss of material from the mould and hence any change in the configuration thereof.

The surface layer of the metallized polymer composition according to the invention, which contains the metal element A and the metal element B, is strongly bonded to the polymeric material. The thickness of the surface layer may range from 0.01 to 100 $\mu$m, preferably from 0.1 to 10 $\mu$m, depending on the process parameters.

Alternatively, said surface layer of the polymeric article may be thickened by further deposition of metal. Since the surface layer formed is electrically conductive it may serve as a preplating in a electrodeposition process. Other, more cumbersome, methods may also be applied. So any metal may be deposited upon the surface layer if reinforcement or functionalization of the surface is the primary object. However, if enhancement of the conductivity is envisaged, it is preferred that use should be made of copper. Electrodeposited copper layers were found to display a strong bond to the surface layers formed according to the invention.

The scope of the invention permits many advantageous uses of the present processes. All fields of application of plated plastics or in the formation of laminates may benefit from the simplicity and convenience of the present processes. The process of the invention may be benefically used, for example, in the manufacture of printed circuit boards, for electromagnetic interference shielding purposes, in the manufacture of membrane switches, for the decorative or functional coating of polymeric articles, for providing wear resistance to polymeric surfaces, for the manufacture of magnetic tapes or discs, anti-static mats or conductive fibers, in the production of capacitors, in the production of barrier polymers, in the production of laminates and in the manufacture of tapes or discs for optical storage.

For example, the surface layers obtained in the process of the invention show an inherent electrical conductivity which is sufficiently high for electromagnetic interference shielding purposes. So in the manufacture of a housing for an electronic device an intimate mixture of acrylonitrile butadiene styrene polymeric material, antimony oxide and trichloro acetic acid ester is injected into a mould lined with metallic copper. During moulding a conductive antimony and copper containing surface layer of the polymeric material is formed at the contact face with the copper lining, providing a conductive coating of the polymeric article upon release from the mould. Generally, this surface layer will be overcoated with a paint for decoration and protection.

In the manufacture of printed circuit boards epoxy resin impregnated substrate boards may be pressed onto stannous chloride coated copper foils, resulting in a conductive surface layer being formed on the substrate board. Common semi-additive printed-circuit processing techniques may then be used to provide a high-conductivity copper circuit pattern.

In the manufacture of membrane switches, for a further example, a paste comprising a mixture of polymeric binder and metallic copper powder coated with antimony trichloride may be applied to a substrate in accordance with a particularly derived circuit pattern. Heating will cause both the curing of the binder and the formation of an antimony-containing coating around each copper particle, so that antimony coatings of adjacent copper particles will coalesce with reduction in the resistivity of the circuit pattern obtained.

The outer surface of the metallic layer deposited on a plastic substrate, by the present process, becomes well adhered to a new plastic surface under the normal laminating conditions known to those familiar in the art. The new plastic surface may or may not be of the same composition or structure as the initial plastic substrate on which the metallization process was carried out. The laminating of different plastics materials through a sandwich layer of metallic composition laid down by the process described herein, leads to strengthening and reinforcement of plastic laminates and enables overcoming incompatibility hindrances associated with the blending and laminating of structurally diverse polymers.

The invention will further be illustrated in the following non-limiting examples.

EXAMPLES

Example 1

Cycolac T 10,000 ABS (Trade mark) (ex. Borg Warner) granules (93.9 g) were compounded with 6.0 g of antimony trichloride (ex. BDH Ltd GPR grade) and 0.1 g of calcium stearate by milling on a two-roll mill (170°C front roll, 165°C back roll) for 5 minutes after gelation.

The milled sheet (1.0-1.2 mm thickness) was cut into 18.5 g portions which were separately compression moulded at 240°C (2 minutes contact time, 5 minutes at 6.15 MPa and 2 minutes at 6.15 MPa for cooling) in contact with a copper-berylium (98:2) foil to yield a blue-orange metallic coating easily separated from the foil upon releasing pressure.

Example 2

100 g of cycolac T 10,000 ABS granules were milled with 0.1 g of calcium stearate, on a two-roll mill (front roll 165°C, back roll 160°C) for 5 minutes after gelation. The milled polymer was preformed into 9 cm x 9 cm x 0.16 cm sheets by compression moulding in a suitable mould at 170°C.

A 9 cm x 9 cm x 0.0125 cm copper-berylium alloy (98 Cu/2 Be) foil was degreased and mounted on a plate and a solution of antimony trichloride in dichloromethane sprayed onto the foil ensuring the uniform deposition of 0.35 g of antimony chloride on the foil surface.

The sprayed alloy foil was placed on a compression mould such that its coated surface is in contact with a surface of the preformed ABS sheet. The polymer in the mould was subject to hot compression (170°C, 6.15 MPa) followed by cooling. The mould was opened and the the ABS sheet found to be coated with a metallic layer which remained adhered to the polymer after separating away the copper-berylium alloy foil. The ABS sheet was found to increase its weight by 2.22%, at the end of the metallization step.

Example 3

Cycolac T 10,000 ABS granules were preformed into 9 cm x 9 cm x 0.16 cm sheets as in example 2.

A 9 cm x 9 cm x 0.0125 cm copper-berylium alloy (98 Cu/2 Be) foil was degreased and mounted on a plate and a solution of antimony trichloride in acetone carrying a suspension of ABS powder - (DSM, MST powder) was sprayed onto the foil.

The sprayed foil was placed over the preformed ABS sheet in a compression mould ensuring that the coated surface was in contact with the polymer surface. The polymer was subjected to hot compression as in example 2.

Example 4

91.55 g of cycolac T 10,000 ABS granules were compounded with 2.0 g of bismuth trioxide, 6.0 g of methyltrichlorobutyrate, 0.3 g of distearyl thiodipropionate, 0.15 g of Irganox 1076 and 0.1 g of calcium stearate as for example 1. Upon compression moulding in contact with a copper-berylium foil as in example 1, a blue-orange metallic coating was formed on the ABS surface adjacent to the contact foil.

## Example 5

91.55 g of cycolac T 10,000 ABS granules were compounded with 4.0 g of stannous oxide, 6.0 g of methyl trichlorobutyrate, 0.3 g of distearyl thiodipropionate, 0.15 g of Irganox 1076 and 0.1 g of calcium stearate as for example 1.

Upon compression moulding as in example 1, a grey metallic coating was formed on the ABS surface.

## Example 6

A 9 cm x 9 cm x 0.15 cm sheet of cycolac T 10,000 ABS polymer was placed next to an anhydrous stannous chloride sprayed copper-berrylium foil and compression moulded for 20 minutes at 240°C (6.15 MPa) to yield a metallic coating on the polymer surface.

## Example 7

90 g of cellulose acetate (Dexel crystal x 1915, Trade mark) was compounded with 10 g of antimony tris(trichlorobutyrate) in a Brabender mixer at 160°C for 5 minutes after gelation.

30 g of the compounded composition was compression moulded at 225°C as in example 1, to yield a metallic coating on the polymer surface.

## Example 8

100 g of PVC (Corvic S 110/17, Trade mark) powder was compounded with 30 g of dioctyl phthalate and 1.0 g of a common barium-zinc stabiliser and milled at 160°C for 5 minutes.

A copper-berrylium alloy foil was sprayed with a solution of antimony trichloride in dichloromethane and a 14.0 g portion of the milled sheet cut and placed in a compression mould, over the coated foil surface.

The polymer was compression moulded at 175°C (6 minutes contact time, 3 minutes at 6.15 MPa) and cooled under 6.15 MPa to yield a metallic coating on the surface of the polymer sheet.

## Example 9

Pre-formed polycarbonate sheets (15 cm x 15 cm x 0.1 cm) were purchased from Goodfellow, Cambridge, England and cut into 14 g pieces measuring 9 cm x 9 cm x 0.1 cm.

A copper-berrylium alloy foil was mounted on a plate and sprayed with a solution of antimony trichloride in dichloromethane.

A polycarbonate piece (14 g) was placed at the bottom of a compression mould chamber and the coated alloy foil positioned on top of the polymer ensuring contact between the polymer and antimony trichloride coated surface. The mould was warmed upto 170°C and after a 6 minute contact time to cause polymer gelation, a pressure of 6.15 MPa was applied for 3 minutes. Upon cooling and opening the mould the outer surface of the polycarbonate sheet was covered with a metallic layer which separated easily from the copper-berrylium foil.

## Example 10

A 9 cm x 9 cm x 0.005 cm Melinex (Trade mark) polyester film was placed next to an antimony trichloride sprayed copper-berrylium foil and compression moulded for 2 minutes at 190°C - (6.15 MPa) to yield a metallic coating on the polymer surface.

## Example 11

A 9 cm x 9 cm x 0.005 cm Kapton (Trade mark) polyimide film was placed next to an antimony trichloride sprayed copper-berrylium foil and compression moulded for 5 minutes at 240°C - (6.15 MPa) to yield a metallic coating on the polymer surface.

## Example 12

A 9 cm x 9 cm x 0.155 cm copper-berrylium foil was sprayed with a solution of antimony trichloride in diethyl ether and the coated foil was placed in a compression mould.

35 g of the epoxy moulding compound, Polyset 217 (ex. Dynachem Corporation, U.S.A., Trade mark) was placed over the coated alloy foil and compression moulded for 2 minutes at 150°C under 6.15 MPa pressure.

After cooling the mould, the epoxy moulding was found to have a metallic coating on the surface that was adjacent to the alloy foil during compression.

## Example 13

79.5 g of Hoechst S 6600 (Trade mark), high impact polystyrene, 10.0 g of titanium dioxide (R 900 Ti pure, Trade mark), 0.5 g of calcium stearate and 10.0 g of antimony tris(trichlorobutyrate) were processed for 5 minutes on a two-roll mill (front roll 210°C, back roll 200°C).

A 8 cm x 8 cm x 0.20 cm piece of processed composition was compression moulded allowing 3 minutes contact time and 6 minutes compression - (6.15 MPa) at 240°C using two copper-berrylium alloy foils adjacent to the polymer.

After cooling, the polymer was found to have a metallic coating on each of the surfaces in contact with the alloy foil during compression.

Example 14

74.9 g of polypropylene (Shell HY 6100 N, Trade mark), 10.0 g of titanium dioxide (R 900 Ti pure), 4.0 g of antimony trioxide, 10.0 g of methyltrichlorobutyrate, 0.5 g of calcium stearate, 0.2 g Irganox 1076 and 0.4 g distearylthiodipropionate were cross-blended on a two-roll mill (front roll 200°C, back roll 190°C) for 5 minutes.

The blended composition was compression moulded by allowing 3 minutes contact time prior to the application of 6.15 MPa pressure for 8 minutes at 240°C after placing copper-berrylium alloy foils on each side of the polymer.

After cooling and foil separation, the polymer surfaces were found to be covered by an adherent metallic coating.

Examples 7-14 show that different polymeric materials, either thermoplastic or thermoset, may be metallized by the process of the invention. The polymer compositions may contain processing aids- such as calcium stearate, and may optionally contain fillers, such as titanium dioxide.

Example 15

A sheet of cycolac T 10,000 ABS polymer (10 cm x 10 cm x 0.2 cm) was sprayed with a solution containing 5 g of antimony trichloride in dichloromethane, followed by fine particle copper powder (3 $\mu$m).

The sheet was transferred to an air circulating oven at 90°C for 10 minutes. The surface of the polymer sheet was found to have a uniform metallic coating.

This example shows that elevated pressures are not essential in the process of the invention. However, elevated pressures do improve the surface finish of the metallic coatings obtained.

Example 16

A 0.1 mm thick copper foil of 110 mm x 150 mm was cleaned by the subsequent steps of etching the oxide skin in a bath containing per liter 100 ml of $H_2SO_4$ and 5 ml of $H_2O_2$ during 30 s at room temperature, rinsing in water during 30 s, cathodic- alkaline degreasing in a commercial degreasing bath during 3 min at 70°C and thoroughly rinsing in cold water during 60 s. The wet copper foil was placed in an antimony plating bath containing per liter 60 g of antimony trioxide, 145 g of potassium citrate and 185 g of citric acid and for 2 min cathodically antimonized at 50°C and a current density of 1 A/dm². An antimony layer of an estimated thickness of about 2 $\mu$m was thus electrodeposited onto the copper foil. The antimony coated copper foil was subsequently rinsed with water and ethanol, dried and immediately placed with its antimony face in contact onto a 2 mm thick ABS sheet of 100 mm x 100 mm (Metzoplast H, $TiO_2$ pigmented of Metzeler GmbH).

This assembly was placed between the two flat press plates of a press preheated to a temperature of 200°C. For 30 s the pressure was gradually increased to a total end load of 500 kg. The pressure and temperature were maintained for a further 90 s, whereupon it was first cooled to a temperature of about 50°C within 5 min, and then the pressure was released and the assembly taken from the press.

Finally the ABS sheet carrying a $Cu_2Sb$ layer was separated from the copper foil.

In similar experiments thicker layers of antimony up to 10 $\mu$m were electro-deposited onto the copper foil yielding thicker $Cu_2Sb$ coatings of the ABS sheets. In many cases the $Cu_2Sb$ coated ABS sheet was spontaneously released from the copper foil due to cooling tensions. In all cases the contact surface of the copper foil after fission only showed traces of residual Sb or $Cu_2Sb$.

The metallic surface layer of the ABS sheet was subjected to X-ray diffraction analysis by means of a Philips PW 1700 powder diffractometer (reflection technique) using $CuK\alpha$ a radiation and a quartz monochromator. The recorded spectrum was computer analyzed, compared with standard spectra of the JCPDS library and demonstrated to be that of the copper-antimony intermetallic compound $Cu_2Sb$.

Measurement of the adhesion of the $Cu_2Sb$-layer to the ABS sheet was attempted on an Elcometer adhesion tester, to which end cylindric aluminium dies were glued onto the fresh $Cu_2Sb$ surface of the coated ABS sheets. In 8 runs break tensions ranging from 150 to 413 N/cm² were observed, however, break occurring at the glue faces or within the ABS sheet. In no case fission was observed at the $Cu_2Sb$/ABS interface.

## Example 17

An antimony coated copper foil was prepared as in Example 16. It was placed upon a 100 mm x 100 mm x 1 mm sheet of polyethersulfon (Ultrason E 2000 of BASF) previously dried at 130°C under vacuum. After being placed in a press at 300°C the assembly was subjected to a load of 500 kg during 5 min at that temperature, whereupon it was cooled and the pressure released to obtain a polyethersulfon sheet having a surface coating of metallic appearance, which by X-ray diffraction was proven to consist of $Cu_2Sb$.

## Example 18

The experiments of Examples 16 and 17 were repeated using other polymeric materials

-polyetheretherketone (Victrex PEEK of ICI)

press conditions: 5 min at 350°C

-polyetherimide (Ultem 1000 of General Electric)

press conditions: 5 min at 350°C

-polyethyleneterephthalate

press conditions: 5 min at 250°C

-polybutyleneterephthalate

press conditions: 5 min at 250°C

-styrene acrylnitrile

press conditions: 5 min at 250°C

In all cases metallized polymer sheets were obtained.

## Example 19

Bonder steel plates were galvanized with sulfamate nickel to produce non-porous nickel coatings of about 10 μm thickness, being sufficiently thick to prevent any exposure of free iron during the subsequent experiments. The nickel coated Bonder plates, after rinsing, were antimonized in the bath and under the conditions described in Example 16. One Ni/Sb-coated plate was preheated during 1 h at 300°C and subsequently pressed onto an ABS-sheet as described in Example 16. A metallized ABS sheet was obtained, of which the surface layer was shown by X-ray diffraction to comprise the intermetallic compounds NiSb and $NiSb_2$.

The other Ni/Sb-coated plates were not preheated, but immediately pressed onto sheets of polyethersulfon, polyetheretherketone and polyetherimide as described before, at temperatures of 325, 350 and 350°C respectively. In all cases intermetallic compound coatings were formed on the polymer sheet, comprising NiSb and/or $NiSb_2$.

No iron was detected in the intermetallic compound layers.

## Example 20

A zinc plate of 100 mm x 100 mm x 1 mm was antimonized in the bath described in Example 16. Although the electroplating appeared to be suboptimal, local areas of antimony coating on the zinc plate could be obtained, which after pressing onto ABS at 250°C produced an intermetallic compound coating comprising SbZn and smaller amounts of $Sb_3Zn_4$.

## Example 21

An indium foil of 100 mm x 15 mm x 1 mm was antimonized as before. In view of the melting point of indium of 156°C the coated foil was pressed onto an ABS sheet at a temperature of 150°C. The surface layer of the metallized ABS sheet comprised the intermetallic compound InSb.

## Example 22

A $Cu_2Sb$ coated ABS sheet obtained as described in Example 16 was electroplated at room temperature and at a current density of 1 A/dm² in a $CuSO_4$ bath. The deposited copper layer showed an excellent adhesion to the $Cu_2Sb$ surface layer of the ABS sheet.

## Claims

1. A metallized polymer composition, of which the surface is at least partially metallized with a surface layer containing a metal element A selected from the group consisting of tin, arsenic, antimony and bismuth and a metal element B selected from the group consisting of iron, cobalt, nickel, copper, zinc, gallium, ruthenium, rhodium, palladium, silver, cadmium and indium.

2. A metallized polymer composition according to claim 1, wherein the metal element A is antimony.

3. A metallized polymer composition according to claim 2, wherein antimony and the metal element B constitute an intermetallic compound.

4. A metallized polymer composition according to claim 3, wherein the surface layer comprises an intermetallic compound of antimony and copper, $Cu_2Sb$.

5. A metallized polymer composition according to any one of the claims 1-4, wherein the surface layer is electrically conductive.

6. A metallized polymer composition according to any one of the claims 1-5, wherein the surface layer has a thickness in the range of from 0.01 to 100 $\mu$m, in particular of from 0.1 to 10 $\mu$m.

7. A metallized polymer composition according to any one of the claims 1-6, wherein the polymer is selected from the group of acrylonitrile-butadiene-styrenes, polyvinylchlorides, polyamides, polypropylenes, polystyrenes, cellulosic acetates, acetals, polyimides, saturated polyesters, polycarbonates, polysulfones, polyethersulfones, polyetherimides, polyetheretherketones, fluorpolymers, polyphenyleneoxidestyrenes, and their mixtures.

8. A metallized polymer composition according to any one of the claims 1-6, wherein the polymer is selected from the group of phenolics, epoxy resins, unsaturated polyesters, polyimides, ethoxylated bisphenol-A-dimethacrylates or mixtures thereof.

9. A process for preparing a metallized polymer composition according to any one of the claims 1-8 in which process a compound or mixture of compounds containing a positively valent metal element A selected from the group consisting of tin, arsenic, antimony and bismuth is brought into reaction with a metallic source of a metal element B selected from the group consisting of iron, cobalt, nickel, copper, zinc, gallium, ruthenium, rhodium, palladium, silver, cadmium, and indium at the surface of the polymer composition to be metallized under conditions such that said metal element is deposited to from a surface layer of the polymer composition containing both the metal element A and the metal element B.

10. A process according to claim 9 characterized in that a support surface is provided which will determine the shape of the surface of the polymer composition to be metallized during the reaction of said compound or mixture of compounds containing a positively valent metal element A.

11. A process according to claim 10, characterized in that the support surface is a metallic surface constituting said metallic source of a metal element B.

12. A process according to any one of the claims 9-11, characterized in that said compound or mixture of compounds containing a positively valent metal element A is incorporated into the polymer composition prior to said reaction.

13. A process according to any one of the claims 9-12, characterized in that said compound or mixture of compounds containing a positively valent metal element A is combined with the metal element B source prior to said reaction.

14. A process according to any of the claims 12 and 13, characterized in that said compound or mixture of compounds is provided between said support surface and the polymer composition prior to said reaction.

15. A process according to claim 14, characterized in that said compound or mixture of compounds is applied to the support surface prior to said reaction.

16. A process according to any one of the claims 10-15, characterized in that the polymer composition is pressed onto the support surface during moulding of the polymeric material to an article.

17. A process according to any one of the claims 9-16, wherein said compound or mixture of compounds comprises a hydride, halide, sulfide, phosphide or carboxylate of the metal element A or its precursors.

18. A process for preparing a metallized polymer composition according to any one of the claims 1-8, in which process at least one layer of zero-valent antimony together with at least one layer of a metal element B selected from the group consisting of iron, cobalt, nickel, copper, zinc, gallium, ruthenium, rhodium, palladium, silver, cadmium and indium are brought into contact with a polymer or prepolymer composition under conditions such that a polymer composition is formed having a surface layer comprising an intermetallic compound of antimony and the metal element B.

19. A process according to claim 18, wherein said layer of a zero-valent metal element B constitutes the surface of a body essentially consisting of said metal element B.

20. A process according to claim 18, wherein said layer of a zero-valent metal element B is a layer deposited upon a release surface.

21. A process according to any of the claims 9-20, wherein use is made of a pressure in the range of from 100 kPa to 10 MPa.

22. A process according to any of the claims 9-12, wherein use is made of a temperature in the range of from ambient temperature to 600°C, in particular of from 125 to 375°C.

23. A process according to any one of the claims 9-22, also comprising the step of further plating at least part of the surface layer formed.

24. Use of the process of any one of the claims 9-23 in the manufacture of printed circuit boards.

25. Use of the process of any one of the claims 9-23 for electromagnetic interference shielding purposes.

26. Use of the process of any one of the claims 9-23 and 30-32 in the manufacture of membrane switches.

27. Use of the process of any one of the claims 9-23, in the manufacture of magnetic tapes or discs.

28. Use of the process of any one of the claims 9-23, in the manufacture of anti-static mats.

29. Use of the process of any one of the claims 9-23, in the manufacture of conductive fibers.

30. Use of the process of any one of the claims 9-23, in the manufacture of capacitors.

31. Use of the process of any one of the claims 9-23, for producing barrier polymers.

32. Use of the process of any one of the claims 9-23, for producing tapes or discs for optical storage.

33. Use of the process of any one of the claims 9-23 for producing tapes or discs for optical modulation and optical switching.

34. A process for producing electrically conductive films, which process comprises the steps of incorporating a compound or mixture of compounds containing a metal element A selected from the group consisting of tin, arsenic, antimony and bismuth and metallic particles containing a metal element B selected from the group consisting of iron, cobalt, nickel, copper, zinc, gallium, ruthenium, rhodium, palladium, silver, cadmium and indium into a thermosetting polymer composition to obtain a paste, spreading said paste to form a film, subjecting said film to heating in such a manner that the thermosetting material is cured and the metal element A is brought into reaction with the metallic particles with formation of a continuous network of interconnected envelopes of individual metallic particles contained in a polymer matrix, said interconnected envelopes containing the metal element A and the metal element B.

35. A paste usable in the process of claim 34, comprising a dispersion of metallic particles as defined therein, being enveloped in a compound or mixture of compounds, as defined therein, in a thermosetting polymeric material.

36. An electrically conductive film obtainable by the process of claim 34.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | BE-A- 792 930 (FORTING LAMINATING CORP.) <br><br> * Page 6, line 3; page 9, lines 33,36 * | 1,5,6-10,13-17,22-24 | B 44 C 1/14 <br> H 05 K 3/02 |
| | --- | | |
| X | DE-A-2 636 095 (V.O.P. INC.) <br><br> * Page 12, line 8; page 7, lines 4,6; page 13, line 3; page 19, line 2 * | 1,5,6-10,13-17,22-24 | |
| | ----- | | |

TECHNICAL FIELDS SEARCHED (Int. Cl.4)

B 44 C
H 05 K
C 23 C

The present search report has been drawn up for all claims

| Place of search | Date of completion of the search | Examiner |
|---|---|---|
| THE HAGUE | 27-08-1986 | NGUYEN THE NGHIEP |